(19) 

Europäisches
Patentamt

European
Patent Office

Office européen
des brevets

(11)  **EP 4 600 682 B1**

(12)  **EUROPEAN PATENT SPECIFICATION**

(45) Date of publication and mention
of the grant of the patent:
**15.07.2026   Bulletin 2026/29**

(21) Application number: **24156370.9**

(22) Date of filing: **07.02.2024**

(51) International Patent Classification (IPC):
***G01R 31/64*** *(2020.01)*

(52) Cooperative Patent Classification (CPC):
**G01R 31/64**

(54) **METHOD AND SYSTEM FOR CAPACITOR LOSS MONITORING FROM LOAD SIGNALS**

VERFAHREN UND SYSTEM ZUR KONDENSATORVERLUSTÜBERWACHUNG AUS
LASTSIGNALEN

PROCÉDÉ ET SYSTÈME DE SURVEILLANCE DE PERTE DE CONDENSATEUR À PARTIR DE
SIGNAUX DE CHARGE

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**

(43) Date of publication of application:
**13.08.2025   Bulletin 2025/33**

(73) Proprietor: **Hitachi Energy Ltd
8050 Zürich (CH)**

(72) Inventors:
• **BENGTSSON, Tord
723 49 Västerås (SE)**

• **GHOSH, Riddhi
722 41 Västerås (SE)**

(74) Representative: **Valea AB
Box 1098
405 23 Göteborg (SE)**

(56) References cited:
**WO-A1-2009/028837        CN-A- 112 639 492
JP-A- 2007 252 057        JP-B2- 6 884 029
KR-B1- 100 998 577        US-A1- 2011 241 695**

## Description

TECHNICAL FIELD

Embodiments herein relate to a system for capacitor monitoring and method performed therein. In particular, embodiments herein relate to power equipment reliability such as measuring a condition of one or more capacitors.

BACKGROUND

Asset monitoring is an important source of information which has a considerable potential for development in the future. However, this is not an easy task, as detailed knowhow about an asset is needed to extract information about an asset in service. The behaviour of the asset needs to be well understood and the precursors of imminent problems must be known. Accordingly, relevant measurement techniques must be developed. Further, these measurements need to be adequately post-processed to remove the effects of disturbances to stabilize the results enough so that a reliable analysis and decision can be made on the state of health or condition of the asset.

Background art is presented in US 2011/241695 A1, which relates to a method performed by a system adapted to measure a condition of one or more capacitors.

Capacitors are widely used in several high voltage applications such as in high voltage direct current (HVDC) applications, harmonic filters and reactive power compensation. There are several monitoring options available for such capacitors, which include measurement of capacitance, loss factor, ESR, remaining life estimation, temperature, etc. The most fundamental of these approaches which requires particular focus on measurement techniques is capacitance and loss factor estimation. Therefore, traditional capacitor assessment focus mainly on these two measured quantities. A common method to obtain the capacitance and loss is to measure the voltage over and the current through the capacitor as these are related by:

$$I = C \frac{dU}{dt}$$

At a constant frequency of the test voltage, the capacitance is obtained as:

$$C = \frac{\hat{I}}{2\pi j f \hat{U}}$$

where Î and Û are the current and voltage amplitudes at frequency *f*. If the amplitudes are extracted as complex numbers, the capacitance is obtained as the magnitude and loss is obtained as the phase angle of the complex capacitance. Approaches based on the latter equation are implemented in many dedicated instruments for capacitance assessment. Most of these instruments can however only be used under laboratory conditions.

While capacitance measurement can be performed and solutions are available for online monitoring, loss factor is a considerably more challenging quantity to measure online. Typical loss factors of healthy capacitors are often less than 0.5 W/kVAr which implies that less than 0.05% of the total current through the capacitor is in phase with the voltage. Such a small value can increase by a factor of 5-10, and yet remain undetected in the complex capacitance. Therefore, this kind of measurement is very delicate, and it needs special attention and expertise to develop loss monitoring systems for capacitors.

SUMMARY

A motivation for developing embodiments herein is that issues have been identified that are caused by capacitors. The capacitors used in the power system are very large and store a lot of energy. A sudden release of this energy by a capacitor failure could have severe consequences. Monitoring the capacitors individual status, e.g. condition, is therefore important to prevent catastrophic failures, and to avoid any unwanted outages in service.

As an electrical component, capacitors are characterized primarily by its capacitance and loss factor. Changes in either of these under constant operating conditions, frequency and voltage, indicates at least that something has happened to the capacitor and is thus a cause for concern. Of course, frequency and voltage are never constant for capacitors in service, and this put an additional layer of difficulty in developing loss monitoring solutions for capacitors.

Measurement of capacitance and loss is a standard practice in high voltage testing for any insulation system, not only capacitors. However, these measurements often require dedicated instruments which cannot be applied in service as they strongly depend on applying a known test voltage waveform to the test object. These instruments usually do not have the power to measure the large capacitors used in power applications, which are of the order of mF, usually the instruments are designed for nF at most. Then they cannot perform the measurements at anything close to service voltage. The required accuracy of these instruments is dictated by the loss factor. The normal and healthy loss factor should be measured with precision enough to see changes. This provides a needed sensitivity target for this work as the monitoring should be able to detect changes of the order of the capacitor loss.

The healthy capacitors typically have a loss of less than 0.5 W/kVAr. This translates to a loss factor of 0.0005 indicating that just 0.05% of the current is in phase with the voltage. This means that changes of around 0.1% need to be detected by the monitoring system, which is a clear challenge for several reasons, some of which are enumerated below.

    1. Sensor accuracy: Normal sensors for current and voltage in the power system, CTs and VTs, have a nominal accuracy around 1%. These values are much higher than the desired accuracy for loss factor measurement.
    2. Frequency and voltage variations: Unlike in the laboratory, monitoring in service involves a frequency and voltage quality that cannot be controlled and can vary significantly. Therefore, the actual frequency must be considered during monitoring.
    3. Noise and disturbances: A small loss factor measurement can easily be compromised by the noise and disturbances present during service conditions.
    4. Algorithms: Apart from measurement-related challenges, the algorithm used to extract the phasors is an important consideration in the development of a capacitor loss factor monitoring system. As mentioned earlier, less than 0.1% of the current is in phase with the voltage, and this needs to be detected in a noisy environment. Therefore, the phasor calculation method employed is perhaps the most critical step in developing the monitoring system.

Considering the above points, it is safe to conclude that accurate loss factor measurement, e.g. in service conditions, is a highly challenging task.

An object of embodiments herein is to provide a mechanism to handle the monitoring of a capacitor in an efficient matter.

According to an aspect of embodiments herein the object is achieved by providing a method performed by a system for measuring a condition of one or more capacitors. The system monitors the one or more capacitors to collect load signals. The system further performs a high precision spectral analysis of the load signals to extract phase vector components from the load signals. The system further detects a change in capacitance and/or loss factor based on the extracted phase vector components.

According to one embodiment, the system may further determine whether the detected change in capacitance and/or loss factor is within a predetermined threshold interval.

According to one embodiment, the system may further issue an alarm when it is determined that the detected change in capacitance and/or loss factor is outside the predetermined threshold interval.

According to one embodiment, the monitoring may be performed in real time.

According to one embodiment, the monitoring may be performed during a predefined time interval.

According to one embodiment, the monitoring may be continuous or periodic.

According to one embodiment, the load signals may be periodic load signals.

According to one embodiment, the load signals may be capacitor load signals

According to one embodiment, the high precision spectral analysis may be performed online and/or in service.

Such a method prevents failure of capacitors that may be in service and/or online. This is beneficial as it improves the overall lifetime of the capacitor.

According to another aspect of embodiments herein, the object is achieved by providing a system configured to measure a condition of one or more capacitors. The system is configured to monitor the one or more capacitors to collect load signals. The system is configured to perform a high precision spectral analysis of the load signals to extract phase vector components from the load signals. The system is further configured to detect a change in capacitance and/or loss factor based on the extracted phase vector components.

Embodiments herein are based on the realisation that by performing a high precision spectral analysis of the collected load signals, changes in capacitance and/or loss factor may be identified which defines the condition of the capacitor and can prevent a failure of the capacitor. Thus, embodiments herein provide a mechanism to handle monitoring of a capacitor in an efficient matter.

BRIEF DESCRIPTION OF THE DRAWINGS

Further objects and advantages, as well as technical features of the invention will become apparent through the following description of one or several embodiments given with reference to the appended figures, where:

Fig. 1　is a flowchart depicting a method according to embodiments herein;
Fig. 2　is an example of a spectra obtained from a high precision alternate current (HPAC) analysis;
Fig. 3　is an example of an evolution of capacitance and loss factor during stress tests on a capacitor; and
Fig. 4　is a block diagram depicting a system according to embodiments herein.

It should be noted that the drawings have not necessarily been drawn to scale and that the dimensions of certain elements may have been exaggerated for the sake of clarity.

DETAILED DESCRIPTION

Embodiments herein will be described in more detail below with reference to the appended figures, in which examples of embodiments are shown. Embodiments herein are not limited to the described examples of embodiments; they are rather defined by the appended patent claims.

An example scenario of the method performed by a system, according to embodiments herein, will now be described. The method enables detecting of changes of the order of the capacitor loss and allows for establishing a condition of the capacitor.

1. Monitoring and analysis of capacitor load signals to detect changes in capacitance and loss factor over time. The monitoring and analysis may be performed online.

2. High precision spectral analysis of the periodic load signals are performed to extract phase vector components from the signals.

3. Capacitance and loss factor is estimated from the phase vectors.

4. The steps of the method may be running in real-time on embedded processors/controllers of the system. Measurements may be continuous or may be operated periodically. Embodiments herein may enable monitoring of loss factor with noise levels of the same order of magnitude as the nominal loss factor.

5. An alarm may be issued for protection against a capacitor catastrophic failure based on a loss factor and/or capacitance threshold level.

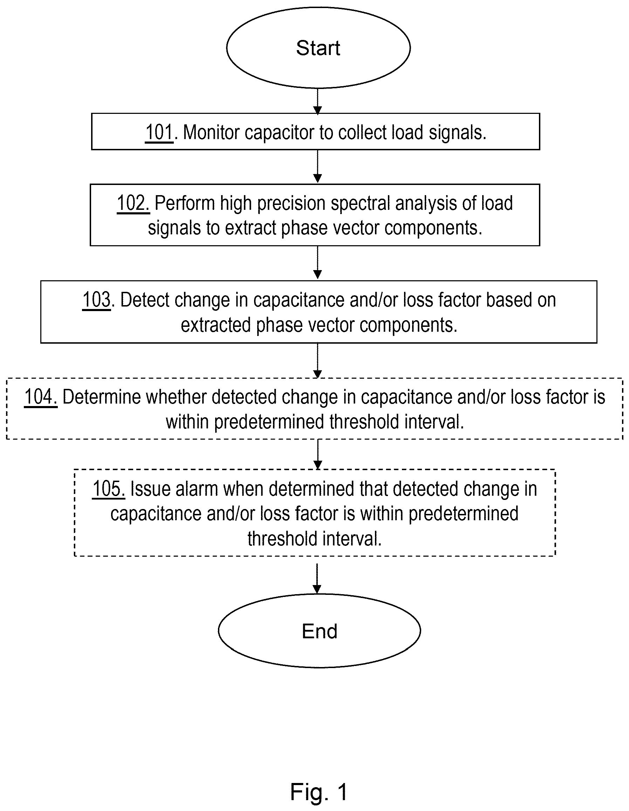

The method actions performed by the system 10 to measure a condition of the one or more capacitors, according to embodiments herein, will now be described with reference to a flowchart depicted in Fig. 1. The actions do not have to be taken in the order stated below but may be taken in any suitable order. Dashed boxes indicate optional features. Embodiments herein relate to monitoring of capacitance and loss factor evolution for one or more capacitors, e.g. in service, with high precision, that is based on determining phase vectors of load signals. The system 10 may be an asset monitoring system focused on capacitors. The system 10 may thus be any system used for asset monitoring, e.g. for measuring a condition of one or more capacitors. All or some of the method actions below may be performed online and/or in service. That the method actions are performed online and/or in service is advantageous because it can enable the detection of capacitor degradation while the capacitors are in operation and warn in advance by identifying the need for maintenance actions. Further, the online monitoring uses the same sensors and other hardware all the time which may not be true for off-line assessments.

**Action 101.**

First the system 10 monitors the one or more capacitors, e.g. power capacitors, to collect load signals. The load signals may be collected by acquiring digital signal streams of the voltage on and the current through the capacitor from voltage and current sensors already available for other purposes at the site. The load signals may be capacitor load signals. The load signals may be derived signals from non-optimal measurement locations. According to some embodiments the monitoring may be performed in real time. The monitoring may be performed during a predefined time interval. An example of a predefined time interval to monitor the one of more capacitors is once every hour to once a day.

According to some embodiments the monitoring may be continuous and/or periodic. Thus, the load signals may be periodic load signals. The load signals can have power system frequency and may therefore be periodic with 20 ms (for 50 Hz). They do not need to be periodic in longer time frames. For a good performance of the spectral analysis, the load signals may be stably oscillating during the analysed time, e.g. about one second.

Continuous monitoring of the capacitor to collect load signals is advantageous because some degradation modes with fast evolution in capacitance and loss factor may be detected and this enables detection of condition changes much earlier than with regular off-line assessment. Furthermore, the online monitoring uses the same sensors and other hardware all the time which may not be true for off-line assessments.

Periodic monitoring of the capacitor to collect load signals is advantageous because it may reduce the hardware needed for monitoring as the same monitoring system may switch between many capacitors.

**Action 102.**

The system 10 then performs a high precision spectral analysis of the load signals to extract phase vector components from the load signals. The spectral analysis may be performed, e.g. of long records, to achieve a high precision as well as to eliminate the need to adjust a sampling rate to the studied frequency. The high precision spectral analysis may allow to monitor, e.g. study, several frequencies simultaneously even if they are not harmonically related. A Gaussian window may be used for the spectral analysis to reduce the sidelobes that otherwise appear in the spectra, which enables to achieve a high precision. The Gaussian window may further define the frequency peak shape and by fitting the known shape to an observed peak, high-precision estimates of both frequency and complex amplitude may be obtained.

According to some embodiments the high precision spectral analysis may be performed online and/or in service. That the high precision spectral analysis is performed online means that the analysis is performed in real-time from load signals under normal capacitor operation either in the laboratory during regular capacitor design and qualification testing and under controlled conditions such as stable frequency and noise conditions.

That the high precision spectral analysis may be performed in service means that the analysis may be performed in real-time from load signals under normal operation on capacitors that are in service in the power network and is exposed to the varying conditions in service such as frequency variations and disturbances.

**Action 103.**

To determine the condition of the one or more capacitors, the system 10 then detects, e.g. estimates, a change in capacitance and/or loss factor based on the extracted phase vector components. A capacitance and/or loss factor at a particular frequency is calculated from the complex capacitance, obtained as:

$$C = \frac{\hat{I}}{2\pi j f \hat{U}}$$

where Î and Û are the current and voltage amplitudes at frequency *f*. The capacitance is obtained as the magnitude and loss is obtained as the phase angle of the complex capacitance.

This value is compared to historic values to find out if there is a significant change. The historic values may simply be base-line values obtained when the monitoring is initiated. They can also be based on statistical analysis or a combination.

**Action 104.**

According to some embodiments the system 10 may determine whether the detected change in capacitance and/or loss factor is within a predetermined threshold interval. The system 10 may, according to some embodiments, determine whether the detected change in capacitance and/or loss factor is above or below a predetermined threshold level. An example of the predetermined threshold interval may be a capacitance decrease by 2-5% and/or a loss factor increase between twice and thrice the nominal loss factor.

**Action 105.**

The system 10 may issue an alarm when it is determined that the detected change in capacitance and/or loss factor is outside the predetermined threshold interval. The predetermined threshold interval may be based on a loss factor threshold level and/or capacitance threshold level. The alarm is thus issued when the condition of the capacitor is deteriorated. The alarm may help an operator to take suitable actions such as replacing the capacitor.

Embodiments herein such as mentioned above will now be further described and exemplified. The text below is applicable to and may be combined with any suitable embodiment described above. Embodiments herein comprises a method that monitors the one or more capacitors to collect load signals and performs high precision spectral analysis of the load signals to extract phase vector components from the load signals. A change in capacitance and/or loss factor is then detected based on the extracted phase vector components. The one or more capacitors may be AC capacitors.

Embodiments herein are thus developed to allow accurate loss factor measurement, e.g. in service conditions and/or online conditions, to establish the condition of the one or more capacitors.

Considering the limitations in monitoring of capacitor loss factor in service, the embodiments herein are based on an accurate detection of changes in loss factor rather than on the absolute loss factor measurement. As discussed above, measuring the absolute loss factor is nearly an impossible task due to sensor limitations. However, although normal sensors for current and voltage in the power system have a nominal accuracy around 1%, experience shows that the sensor stability is better than sensor accuracy by a factor of ten. This implies that although the precise loss factor may be difficult to measure, it is possible to measure the changes in the loss factor over time with relatively acceptable accuracy. While the absolute value might be offset within the stipulated accuracy range, the sensor offset will be much more stable so that smaller changes in the measured signals can be readily detected.

Embodiments herein are based on an algorithm for phasor estimation from periodic waveforms at a high precision. The high precision algorithm, i.e., the high precision spectral analysis can calculate phasors in a more versatile and accurate way as compared to standard spectral analysis approaches, e.g., Discrete Fourier Transform (DFT). The high precision spectral analysis uses spectral analysis of long records to achieve a high precision, as well as to eliminate the need to adjust sampling rate to the studied frequency, which is needed in the standard spectral analysis approaches, e.g., DFT approach.

Many frequencies can be studied simultaneously, even if they are not harmonically related. It uses a Gaussian window for the spectral analysis to reduce the sidelobes that otherwise appear in the spectra, and this helps to achieve a high precision. The Gaussian window further defines the frequency peak shape and by fitting the known shape to an observed peak, high-precision estimates of both frequency and complex amplitude are obtained. Under laboratory conditions, accuracies as high as 1 ppm have been demonstrated, whereas for most power system signals the observed noise limit is around 100 - 1000 ppm. For loss factor monitoring, the high precision algorithm provides a way to study the evolution of the losses with a high degree of accuracy, which would be otherwise nearly impossible.

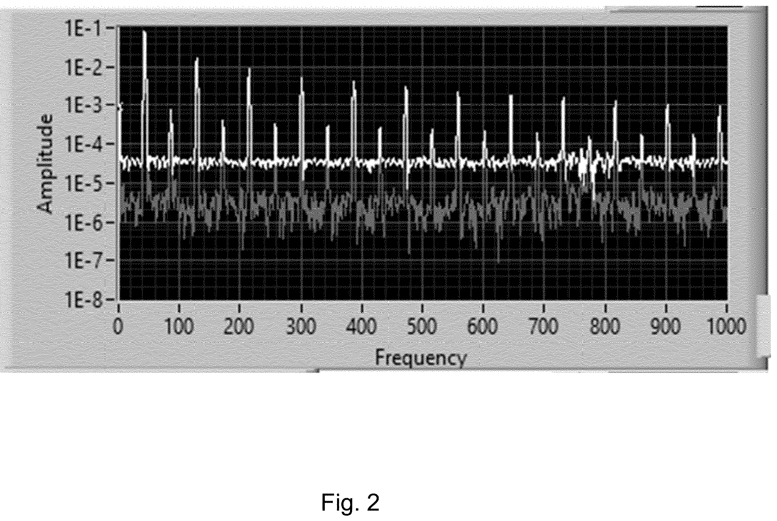

**Fig. 2** illustrates an example of a spectra obtained during laboratory measurements of capacitor voltage and current, showing the low noise level in the measurements. The example spectra in Fig. 2 obtained from the high precision spectral analysis of the voltage (shown as white in the figure) and current channels (shown as grey in the figure) showing the low noise level in the measurements. Data corresponds to laboratory measurement with controlled frequency and a voltage signal rich in harmonics.

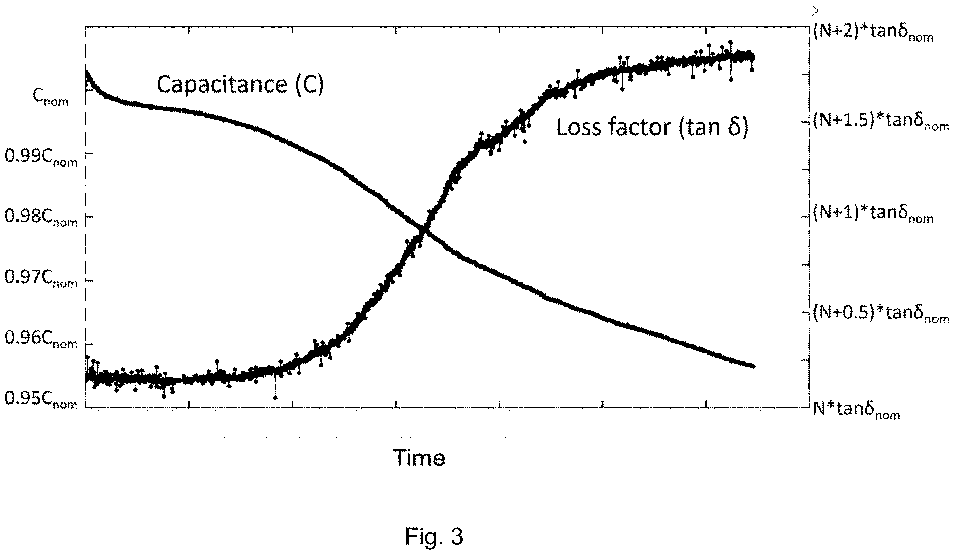

**Fig. 3** illustrates the evolution in loss factor and capacitance during tests in the laboratory measurements. The nominal capacitance and loss factor are denoted by $C_{nom}$ and $tan\ \delta_{nom}$. N compared to the true loss factor $tan\ \delta_{nom}$. $\delta_{nom}$ in Fig. 3 means that the observed change corresponds to twice the nominal loss factor. The offset in the loss factor on account of sensor accuracy was therefore $(N-1)*tan\ \delta_{nom}$. This is why at the beginning of the test a loss factor of $N*tan\ \delta_{nom}$ is observed whereas the true loss factor measured using an LCR meter is $tan\ \delta_{nom}$. measurement is low. Therefore, the evolution or change in loss factor could be measured with sufficient sensitivity. Similar to the loss factor change, the change in capacitance illustrates a drop by about 5% during the test duration.

Failures of capacitors, e.g. online and/or in service may be avoided by using the embodiments herein as a basis for developing online loss factor monitoring solutions for capacitors. Furthermore, high precision laboratory qualification testing for capacitor elements can enable clearer understanding of the capacitor aging behaviour under AC voltage. Embodiments herein can be applied for load signal monitoring of other apparatuses and is not limited to power products.

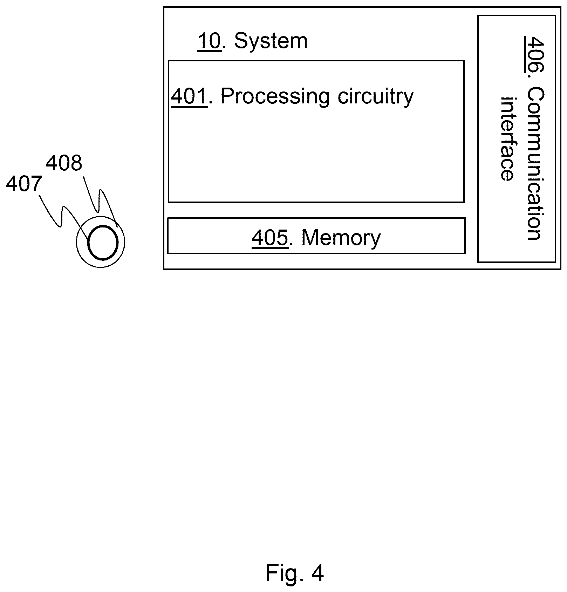

**Fig. 4** is a block diagram depicting embodiments of the system 10 adapted to measure a condition of the one or more capacitors according to embodiments herein. The block diagram in Fig. 4 thus illustrates a detailed but non-limiting schematic example of how the system 10 may be structured to bring about the above-described solution and embodiments thereof. The system 10 may be configured to operate according to any of the examples and embodiments of employing the solution as described herein, where appropriate. The system 10 may be a control system or any system used for asset monitoring, e.g. for measuring a condition of one or more capacitors. The system 10 may be a system for monitoring load signals and measuring a loss factor of a capacitor, such as a loss factor measurement system or a monitoring system.

The system 10 may comprise **processing circuitry 401,** e.g., one or more processors, configured to perform the methods herein.

The system 10 and/or the processing circuitry 401 is configured to monitor the one or more capacitors to collect load signals. The monitoring may be performed in real time. The monitoring may be continuous and/or periodic.

The system 10 and/or the processing circuitry 401 is configured to perform a high precision spectral analysis of the load signals to extract phase vector components from the load signals. The high precision spectral analysis may be performed online and/or in service.

The system 10 and/or the processing circuitry 401 is configured to detect a change in capacitance and/or loss factor based on the extracted phase vector components. The system 10 and/or the processing circuitry 401 may be configured to determine whether the detected change in capacitance and/or loss factor is within a predetermined threshold interval.

The system 10 and/or the processing circuitry 401 may be configured to issue an alarm when it is determined that the detected change in capacitance and/or loss factor is within the predetermined threshold interval.

The system 10 may comprise **a memory 405.** The memory 405 comprises one or more units to be used to store data on, such as signals, measurements, measurement data, load signals, loss factor data, phase vector components and applications to perform the methods disclosed herein when being executed, and similar. Furthermore, the system 10 may comprise **a communication interface 406** comprising such as a transmitter, a receiver and/or a transceiver.

The methods according to the embodiments described herein for the system 10 are respectively implemented by means of e.g., **a computer program product 407** or a computer program, comprising instructions, i.e., software code portions, which, when executed on at least one processor, cause the at least one processor to carry out the actions described herein, as performed by the system 10. The computer program product 407 may be stored on **a computer-readable storage medium 408,** e.g., a disc, a universal serial bus (USB) stick or similar. The computer-readable storage medium 408, having stored thereon the computer program product, may comprise the instructions which, when executed on at least one processor, cause the at least one processor to carry out the actions described herein, as performed by the system 10. In some embodiments, the computer-readable storage medium may be a transitory or a non-transitory computer-readable storage medium. Thus, embodiments herein may disclose a system adapted to measure a condition of one or more capacitors, wherein the system comprises processing circuitry and a memory, said memory comprising instructions executable by said processing circuitry whereby said system is operative to perform any of the methods herein.

As will be readily understood by those familiar with communications design, that functions means or circuits may be implemented using digital logic and/or one or more microcontrollers, microprocessors, or other digital hardware. In some embodiments, several or all of the various functions may be implemented together, such as in a single Application-Specific Integrated Circuit (ASIC), or in two or more separate devices with appropriate hardware and/or software interfaces between them. Several of the functions may be implemented on a processor shared with other functional components of a wireless device or network node, for example.

Alternatively, several of the functional elements of the processing means discussed may be provided through the use of dedicated hardware, while others are provided with hardware for executing software, in association with the appropriate software or firmware. Thus, the term "processor" or "controller" as used herein does not exclusively refer to hardware capable of executing software and may implicitly include, without limitation, Digital Signal Processor (DSP) hardware and/or program or application data. Other hardware, conventional and/or custom, may also be included. Designers of communications devices will appreciate the cost, performance, and maintenance trade-offs inherent in these design choices.

Any appropriate steps, methods, features, functions, or benefits disclosed herein may be performed through one or more functional units or modules of one or more virtual apparatuses. Each virtual apparatus may comprise a number of these functional units. These functional units may be implemented via processing circuitry, which may include one or more microprocessor or microcontrollers, as well as other digital hardware, which may include DSPs, field-programmable gate arrays (FPGAs), special-purpose digital logic, and the like. The processing circuitry may be configured to execute program code stored in memory, which may include one or several types of memory such as Read-Only Memory (ROM), Random-Access Memory (RAM), cache memory, flash memory devices, optical storage devices, etc. Program code stored in memory includes program instructions for executing one or more telecommunications and/or data communications protocols as well as instructions for carrying out one or more of the techniques described herein. In some implementations, the processing circuitry may be used to cause the respective functional unit to perform corresponding functions according to one or more embodiments of the present disclosure.

The processing circuitry 401 in the system 10 thus comprises equipment configured for communication using a suitable protocol for the communication depending on the implementation. The data communication link between the different parts of the system 10, e.g. between sensors and the system 10 in a cloud 50 or locally, may for an example utilize one or a plurality of different types of wired links or wireless links, such as for example xDSL, 2G, 3G, 4G, 5G TCP/IP, Wi-Fi, Bluetooth, WiMax, WLL, PSTN, optical fibre or a combination thereof. The solution is however not limited to any specific types of messages or protocols. For example, the system 10 may be adapted to communicate with a control centre or the like.

While the solution has been described with reference to specific exemplifying embodiments, the description is generally only intended to illustrate the inventive concept and should not be taken as limiting the scope of the solution. For example, the terms "data", "load signals", "phase vector components", "system" and "alarm", have been used throughout this disclosure, although any other corresponding entities, functions, and/or parameters could also be used having the features and characteristics described here. The solution is defined by the appended claims.

It will be appreciated that the foregoing description and the accompanying drawings represent non-limiting examples of the method and arrangement taught herein. As such, the arrangement and techniques taught herein are not limited by the foregoing description and accompanying drawings. Instead, the embodiments herein are limited only by the following claims.

**Claims**

1. Method performed by a system (10) adapted to measure a condition of one or more capacitors, the method comprising:
   *monitoring* (101) the one or more capacitors to collect load signals; and the method being **characterized in that** it further comprises:

   > *performing* (102) a high precision spectral analysis of the load signals to extract phase vector components from the load signals; and
   > *detecting* (103) a change in capacitance and/or loss factor based on the extracted phase vector components.

2. The method according to claim 1, wherein the high precision spectral analysis is performed online and/or in service.

3. The method according to claim 1 or 2, further comprising:
   *determining* (104) whether the detected change in capacitance and/or loss factor is within a predetermined threshold interval.

4. The method according to any one of claims 1-3, further comprising:
   *issuing* (105) an alarm when it is determined that the detected change in capacitance and/or loss factor is outside the predetermined threshold interval.

5. The method according to any one of claims 1-4, wherein the monitoring is performed in real time.

6. The method according to any one of claims 1-5, wherein the monitoring is performed during a predefined time interval.

7. The method according to any one of claims 1-6, wherein the monitoring is continuous and/or periodic.

8. The method according to any one of claims 1-7, wherein the load signals are periodic load signals.

9. The method according to any one of claims 1-8, wherein the load signals are capacitor load signals.

10. System (10) configured to measure a condition of one or more capacitors, wherein the system (10) is configured to:

monitor the one or more capacitors to collect load signals; and

wherein the system (10) is **characterized in that** it is further configured to:

perform a high precision spectral analysis of the load signals to extract phase vector components from the load signals; and

detect a change in capacitance and/or loss factor based on the extracted phase vector components.

11. The system (10) according to claim 10, wherein the system (10) is configured to:

determine whether the detected change in capacitance and/or loss factor is within a predetermined threshold interval.

12. The system (10) according to claim 10 or 11, wherein the system (10) is configured to:

issue an alarm when it is determined that the detected change in capacitance and/or loss factor is outside the predetermined threshold interval.

13. The system (10) according to any one of claims 10-12, wherein the high precision spectral analysis is performed online and/or in service.

14. The system (10) according to any one of claims 10-13, wherein the monitoring is performed in real time.

15. The system (10) according to any one of claims 10-14, wherein the monitoring is continuous and/or periodic.

## Patentansprüche

1. Verfahren, das durch ein System (10) durchgeführt wird, das dazu konfiguriert ist, einen Zustand eines oder mehrerer Kondensatoren zu messen, wobei das Verfahren Folgendes umfasst:

*Überwachen* (101) des einen oder mehrerer Kondensatoren, um Lastsignale zu sammeln; und

wobei das Verfahren **dadurch gekennzeichnet ist, dass** es ferner Folgendes umfasst:

*Durchführen* (102) einer hochgenauen Spektralanalyse der Lastsignale, um Phasenvektorkomponenten aus den Lastsignalen zu extrahieren; und

*Detektieren* (103) einer Änderung der Kapazität und/oder des Verlustfaktors basierend auf den extrahierten Phasenvektorkomponenten.

2. Verfahren nach Anspruch 1, wobei die hochgenaue Spektralanalyse online und/oder im Betrieb durchgeführt wird.

3. Verfahren nach Anspruch 1 oder 2, das ferner Folgendes umfasst:

*Bestimmen* (104), ob die detektierte Änderung der Kapazität und/oder des Verlustfaktors innerhalb eines vorbestimmten Schwellenintervalls liegt.

4. Verfahren nach einem der Ansprüche 1-3, das ferner Folgendes umfasst:

*Ausgeben* (105) eines Alarms, wenn bestimmt wird, dass die detektierte Änderung der Kapazität und/oder des Verlustfaktors außerhalb des vorbestimmten Schwellenintervalls liegt.

5. Verfahren nach einem der Ansprüche 1-4, wobei das Überwachen in Echtzeit durchgeführt wird.

6. Verfahren nach einem der Ansprüche 1-5, wobei das Überwachen während eines vordefinierten Zeitintervalls durchgeführt wird.

7. Verfahren nach einem der Ansprüche 1-6, wobei das Überwachen kontinuierlich und/oder periodisch erfolgt.

8. Verfahren nach einem der Ansprüche 1-7, wobei die Lastsignale periodische Lastsignale sind.

9. Verfahren nach einem der Ansprüche 1-8, wobei die Lastsignale Kondensatorlastsignale sind.

10. System (10), das dazu konfiguriert ist, einen Zustand eines oder mehrerer Kondensatoren zu messen, wobei das System (10) dazu konfiguriert ist:

den einen oder mehrere Kondensatoren zu überwachen, um Lastsignale zu sammeln; und wobei das System (10) **dadurch gekennzeichnet ist, dass** es ferner dazu konfiguriert ist: eine hochgenaue Spektralanalyse der Lastsignale durchzuführen, um Phasenvektorkomponenten aus den Lastsignalen zu extrahieren; und

eine Änderung der Kapazität und/oder des Verlustfaktors basierend auf den extrahierten Phasenvektorkomponenten zu detektieren.

**11.** System (10) nach Anspruch 10, wobei das System (10) dazu konfiguriert ist:
zu bestimmen, ob die detektierte Änderung der Kapazität und/oder des Verlustfaktors innerhalb eines vorbestimmten Schwellenintervalls liegt.

**12.** System (10) nach Anspruch 10 oder 11, wobei das System (10) dazu konfiguriert ist:
einen Alarm auszugeben, wenn bestimmt wird, dass die detektierte Änderung der Kapazität und/oder des Verlustfaktors außerhalb des vorbestimmten Schwellenintervalls liegt.

**13.** System (10) nach einem der Ansprüche 10-12, wobei die hochgenaue Spektralanalyse online und/oder im Betrieb durchgeführt wird.

**14.** System (10) nach einem der Ansprüche 10-13, wobei das Überwachen in Echtzeit durchgeführt wird.

**15.** System (10) nach einem der Ansprüche 10-14, wobei das Überwachen kontinuierlich und/oder periodisch erfolgt.


**Revendications**

**1.** Procédé mis en œuvre par un système (10) adapté pour mesurer l'état d'un ou plusieurs condensateurs, le procédé comprenant :

la surveillance (101) des un ou plusieurs condensateurs afin de collecter des signaux de charge ; et
le procédé étant **caractérisé en ce qu'**il comprend en outre :

la réalisation (102) d'une analyse spectrale de haute précision des signaux de charge afin d'extraire des composantes du vecteur de phase à partir des signaux de charge ; et
la détection (103) d'une variation de la capacité et/ou du facteur de perte sur la base des composantes du vecteur de phase extraites.

**2.** Procédé selon la revendication 1, dans lequel l'analyse spectrale de haute précision est effectuée en ligne et/ou en cours de service.

**3.** Procédé selon la revendication 1 ou la revendication 2, comprenant en outre :
le fait de déterminer (104) si la variation détectée de la capacité et/ou du facteur de perte est située dans un intervalle de seuil prédéterminé.

**4.** Procédé selon l'une quelconque des revendications 1 à 3, comprenant en outre :

l'émission (105) d'une alarme lorsqu'il est déterminé que la variation détectée de la capacité et/ou du facteur de perte est située en dehors de l'intervalle de seuil prédéterminé.

**5.** Procédé selon l'une quelconque des revendications 1 à 4, dans lequel la surveillance est effectuée en temps réel.

**6.** Procédé selon l'une quelconque des revendications 1 à 5, dans lequel la surveillance est effectuée pendant un intervalle de temps prédéfini.

**7.** Procédé selon l'une quelconque des revendications 1 à 6, dans lequel la surveillance est continue et/ou périodique.

**8.** Procédé selon l'une quelconque des revendications 1 à 7, dans lequel les signaux de charge sont des signaux de charge périodiques.

**9.** Procédé selon l'une quelconque des revendications 1 à 8, dans lequel les signaux de charge sont des signaux de charge de condensateur.

**10.** Système (10) configuré pour mesurer l'état d'un ou plusieurs condensateurs, le système (10) étant configuré pour :
surveiller les un ou plusieurs condensateurs afin de collecter des signaux de charge ; et dans lequel le système (10) est **caractérisé en ce qu'**il est en outre configuré pour :

effectuer une analyse spectrale de haute précision des signaux de charge afin d'extraire des signaux de charge des composantes du vecteur de phase ; et
détecter une variation de la capacité et/ou du facteur de perte sur la base des composantes du vecteur de phase extraites.

**11.** Système (10) selon la revendication 10, le système (10) étant configuré pour :
déterminer si la variation détectée de la capacité et/ou du facteur de perte est située dans un intervalle de seuil prédéterminé.

**12.** Système (10) selon la revendication 10 ou la revendication 11, le système (10) étant configuré pour :
émettre une alarme lorsqu'il est déterminé que la variation détectée de la capacité et/ou du facteur de perte est située en dehors de l'intervalle de seuil prédéterminé.

**13.** Système (10) selon l'une quelconque des revendications 10 à 12, dans lequel l'analyse spectrale de haute précision est effectuée en ligne et/ou en cours de service.

**14.** Système (10) selon l'une quelconque des revendications 10 à 13, dans lequel la surveillance est effectuée en temps réel.

**15.** Système (10) selon l'une quelconque des revendications 10 à 14, dans lequel la surveillance est continue et/ou périodique.

Start

101. Monitor capacitor to collect load signals.

102. Perform high precision spectral analysis of load signals to extract phase vector components.

103. Detect change in capacitance and/or loss factor based on extracted phase vector components.

104. Determine whether detected change in capacitance and/or loss factor is within predetermined threshold interval.

105. Issue alarm when determined that detected change in capacitance and/or loss factor is within predetermined threshold interval.

End

Fig. 1

Fig. 2

Fig. 3

EP 4 600 682 B1

Fig. 4

**EP 4 600 682 B1**

**REFERENCES CITED IN THE DESCRIPTION**

**Patent documents cited in the description**

- US 2011241695 A1